# EUROPEAN PATENT APPLICATION

(11) **EP 4 432 335 A2**
(43) Date of publication of application: **18.09.2024**
(21) Application number: 24161276.1
(22) Date of filing: 04.03.2024
(51) Int. Cl.: H01L 21/67, H01L 21/677, H01L 21/68

(54) **SUBSTRATE PROCESSING APPARATUS AND SUBSTRATE PROCESSING METHOD**

(30) Priority: 16.03.2023 JP 2023042186
(71) Applicant: SCREEN Holdings Co., Ltd., Kyoto-shi, Kyoto 602-8585 (JP)
(72) Inventor: GOTO, Shigehiro, Kyoto-shi, 602-8585 (JP); SUZUKI, Masafumi, Kyoto-shi, 602-8585 (JP)
(74) Representative: Kilian Kilian & Partner mbB

(57) **Abstract**

An upper surface of a substrate that is carried into a substrate processing apparatus includes a valid area in which a circuit pattern is formed or to be formed and an invalid area. In a substrate rotator, an image of the substrate is picked up, so that the invalid area is identified. Based on invalid area information and information in regard to an abnormal film-thickness portion that is predicted in advance, a portion in which an abnormal film-thickness portion can be arranged in the invalid area is extracted. A rotation position of the substrate is adjusted such that an extracted portion in the invalid area is located in one end portion in a moving direction of a slit nozzle during a coating process. The substrate the rotation position of which is adjusted by the substrate rotator is transferred to a coating processor by a receiver-transferer.

## Description

### BACKGROUND

### Technical Field

The present disclosure relates to a substrate processing apparatus and a substrate processing method for formation of a film of a processing liquid on an upper surface of a substrate.

### Description of Related Art

A substrate processing apparatus is used to perform various processes on a substrate such as a semiconductor substrate, a substrate for an FPD (Flat Panel Display) that is used for a liquid crystal display device, an organic EL (Electro Luminescence) display device or the like, a substrate for an optical disc, a substrate for a magnetic disc, a substrate for a magneto-optical disc, a substrate for a photomask, a ceramic substrate or a substrate for a solar cell.

As an example of the substrate processing apparatus, there is a coating processing device that applies a processing liquid to a substrate with use of a nozzle having a slit-like discharge port (hereinafter referred to as a slit nozzle). For example, in a coating device (coating processing device) described in JP 2017-164700 A, a slit nozzle is moved in the space above a circular substrate held in a horizontal attitude while discharging a processing liquid. During this movement, the opening width of a discharge port is adjusted to match the dimension of the substrate such that an excess processing liquid is not discharged to an area outside of the substrate.

In the meantime, in the coating processing device with use of the slit nozzle, when the slit nozzle is separated from the substrate after the slit nozzle is moved in the space above the substrate while discharging the processing liquid, a liquid pool of the processing liquid is generated on the substrate. The liquid pool of the processing liquid generates a portion in which the thickness of a film is locally changed on the substrate after the coating process. Such an occurrence of an abnormal film-thickness portion may adversely affect the subsequent process for the substrate.

In view of this, in the substrate coating device described in JP 2022-143661 A, the substrate is arranged such that a cutout portion is located in the terminal position in the moving direction of the slit nozzle before the coating process is started. The coating process is performed in this state, so that when the processing liquid is applied to the entire upper surface of the substrate, and the slit nozzle is separated from the substrate, a liquid pool is generated in an area in the vicinity of the cutout portion. In the substrate, the cutout portion is located outside of a valid area in which a circuit pattern or the like is formed. Therefore, a liquid pool is generated only outside of the valid area.

### SUMMARY

However, depending on the shape of the cutout portion, the distance between the cutout portion and the valid area, and the like, it may not actually be possible to arrange an abnormal film-thickness portion outside of the valid area.

An object of the present disclosure is to provide a substrate processing apparatus and a substrate processing method with which a processing defect of a substrate caused by a process of applying a processing liquid can be reduced.

A substrate processing apparatus according to one aspect of the present disclosure forms a film of a processing liquid on an upper surface of a substrate having an at least partially circular outer periphery, wherein the upper surface of the substrate includes a valid area in which a circuit pattern is formed or to be formed and an invalid area excluding the valid area, and the substrate processing apparatus includes a substrate holder that holds the substrate, a nozzle that has a slit-like discharge port extending in a first direction and discharges the processing liquid from the discharge port to the substrate held by the substrate holder, a mover that performs a relative moving work for relative movement of at least one of the substrate holder and the nozzle with respect to another one in a second direction intersecting with the first direction such that the nozzle passes through a space above the substrate while discharging the processing liquid to the substrate, an acquirer that acquires invalid area information representing the invalid area in the upper surface of the substrate before the relative moving work is performed, and an adjuster that adjusts a rotation position of the substrate held by the substrate holder based on the invalid area information acquired by the acquirer before the relative moving work is performed.

A substrate processing method according to another aspect of the present disclosure of forming a film of a processing liquid on an upper surface of a substrate having an at least partially circular outer periphery, wherein the upper surface of the substrate includes a valid area in which a circuit pattern is formed or to be formed and an invalid area excluding the valid area, and the substrate processing method includes holding the substrate using a substrate holder, a relative moving step of relatively moving at least one of the substrate holder and the nozzle with respect to another one in a second direction intersecting with a first direction such that a nozzle having a slit-like discharge port extending in the first direction passes through a space above the substrate while discharging the processing liquid from the discharge port to the substrate held by the substrate holder, a relative moving step of relatively moving at least one of the substrate holder and the nozzle with respect to another one in a second direction intersecting with a first direction such that a nozzle having a slit-like discharge port extending in the first direction passes through a space above the substrate while discharging the processing liquid from the discharge port to the substrate held by the substrate holder, acquiring invalid area information representing the invalid area in the upper surface of the substrate before the relative moving step, and adjusting a rotation position of the substrate held by the substrate holder based on the invalid area information acquired in the acquiring before the relative moving step.

With the present disclosure, it is possible to reduce a processing defect of a substrate caused by a process of applying a processing liquid.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a schematic diagram showing the basic configuration of a substrate processing apparatus according to a first embodiment;
Fig. 2 is an external perspective view of a coating processor of Fig. 1;
Fig. 3 is a schematic plan view for explaining a series of works in the substrate processing apparatus of Fig. 1;
Fig. 4 is a schematic plan view for explaining the series of works in the substrate processing apparatus of Fig. 1;
Fig. 5 is a schematic plan view for explaining the series of works in the substrate processing apparatus of Fig. 1;
Fig. 6 is a schematic plan view for explaining the series of works in the substrate processing apparatus of Fig. 1;
Fig. 7 is a diagram for explaining extraction of a portion in which an abnormal film-thickness portion can be arranged from an invalid area on a substrate;
Fig. 8 is a block diagram showing the configuration of a control system of the substrate processing apparatus of Fig. 1;
Fig. 9 is a flowchart showing one example of a series of processes performed by a CPU of a control device; and
Fig. 10 is a block diagram showing the configuration of a control system of a substrate processing apparatus according to a second embodiment.

### DETAILED DESCRIPTION

A substrate processing apparatus and a substrate processing method according to one embodiment of the present disclosure will be described below with reference to the drawings. In the following description, a substrate refers to a substrate for an FPD (Flat Panel Display) that is used for a liquid crystal display device, an organic EL (Electro Luminescence) display device or the like, a semiconductor substrate, a substrate for an optical disc, a substrate for a magnetic disc, a substrate for a magneto-optical disc, a substrate for a photomask, a ceramic substrate, a substrate for a solar cell or the like. A substrate described below is a substrate that is at least partially circular and is a circular substrate in which a notch, an orientation flat or the like is formed. Further, in a substrate processing apparatus described below, various processes are performed with a main surface (a surface on which a circuit pattern is formed or a circuit pattern is to be formed) of the substrate directed upwardly.

### 1. First Embodiment

### <1> Basic Configuration of Substrate Processing Apparatus

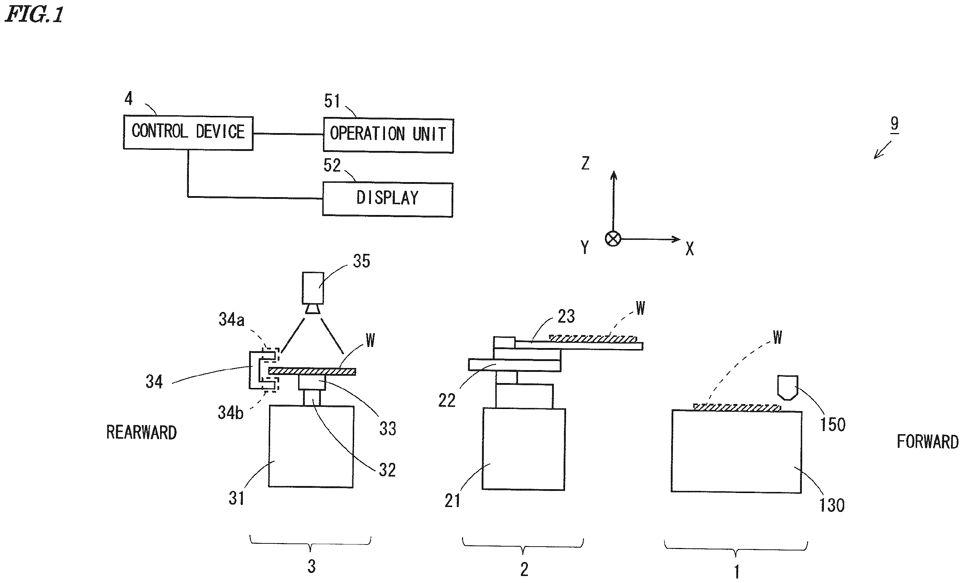

Fig. 1 is a schematic diagram showing the basic configuration of a substrate processing apparatus according to a first embodiment. Fig. 1 and the subsequent drawings are accompanied by arrows that indicate X, Y and Z directions orthogonal to one another for the clarity of a positional relationship among respective components of the substrate processing apparatus 9. The X and Y directions are orthogonal to each other within a horizontal plane, and the Z direction corresponds to an upward-and-downward direction (vertical direction).

In the present embodiment, a notch is formed in part of the outer peripheral end of a substrate W to be carried into the substrate processing apparatus 9. Further, a plurality of circuit patterns are formed in a predetermined arrangement on the upper surface of the substrate W. In the following description, an area in which a plurality of circuit patterns are formed in the upper surface of the substrate W is referred to as a valid area, and an area other than the valid area in the upper surface of the substrate W is referred to as an invalid area.

As shown in Fig. 1, the substrate processing apparatus 9 according to the present embodiment mainly includes a coating processor 1, a receiver-transferer 2, a substrate rotator 3 and a control device 4. The coating processor 1, the receiver-transferer 2 and the substrate rotator 3 are arranged in this order in a line in the X direction. Here, in the substrate processing apparatus, the direction directed from the coating processor 1 toward the substrate rotator 3 in the X direction is referred to as rearward, and the direction opposite to rearward is referred to as forward. Further, in the Y direction, the leftward direction with a person facing forwardly of the substrate processing apparatus 9 is referred to as leftward, and the direction opposite to leftward is referred to as rightward.

The coating processor 1 includes a stage device 130 and a nozzle device 150. The stage device 130 is configured such that the substrate W can be placed and held in a horizontal attitude. The nozzle device 150 supplies a predetermined processing liquid onto the upper surface of the substrate W held by the stage device 130, thereby forming a film of the processing liquid on the upper surface of the substrate W (a coating process). The processing liquid to be used in a coating device 100 is a coating liquid for a resist film (resist liquid) or a coating liquid for an anti-reflection film (an anti-reflection liquid). Details of the configuration of the coating processor 1 and the work of the coating processor 1 during the coating process will be described below.

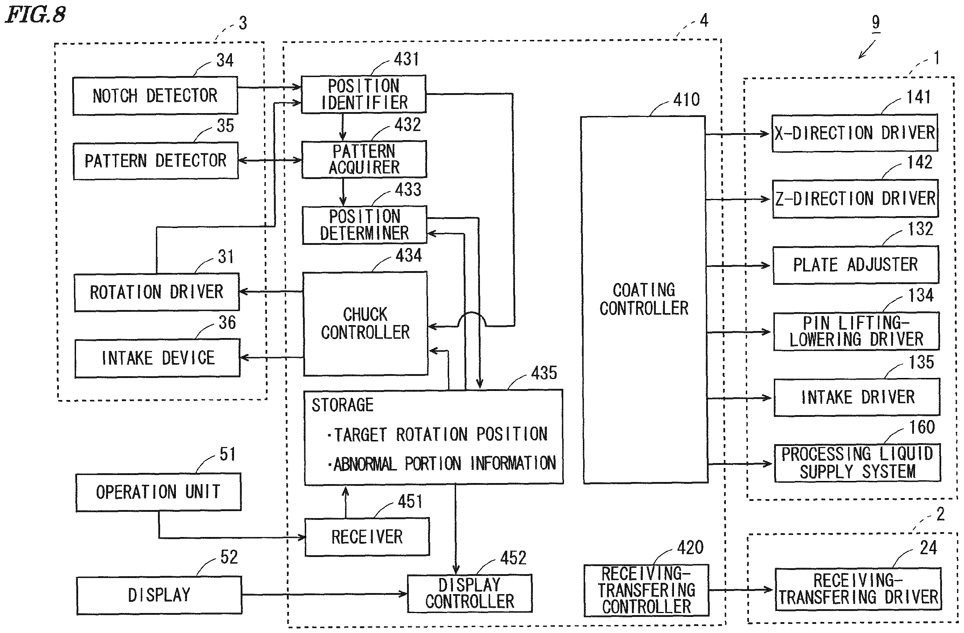

The substrate rotator 3 includes a rotation driver 31, a rotation holder 33, a notch detector 34 and a pattern detector 35. The rotation driver 31 is an electric motor, for example, and has a rotation shaft 32 extending upwardly. The rotation holder 33 is configured to be capable of holding the center portion of the lower surface of the substrate W by suction, and is attached to the upper end portion of the rotation shaft 32. In the rotation shaft 32, an intake path for holding the substrate W by suction is formed in the rotation holder 33. The intake path is connected to an intake device 36 of Fig. 8, described below. The rotation driver 31 rotates the rotation holder 33 about the rotation shaft 32.

The notch detector 34 of the present example is a transmission-type photoelectric sensor including a light emitting element 34a and a light receiving element 34b. The light emitting element 34a and the light receiving element 34b are arranged so as to interpose part of the outer peripheral end of the substrate W held by suction by the rotation holder 33 in the upward-and-downward direction. In this state, the rotation holder 33 is rotated. At this time, light is emitted from the light emitting element 34a toward the light receiving element 34b. The light receiving element 34b outputs a detection signal corresponding to an amount of received light.

In a case in which the substrate W held by the rotation holder 33 is rotated, the notch passes between the light emitting element 34a and the light receiving element 34b in a period during which the substrate W is rotated once. At this time, a detection signal output from the light receiving element 34b is temporarily changed. In the above-mentioned rotation driver 31, an encoder that outputs a signal corresponding to a rotation angle of the rotation shaft 32 is incorporated. Thus, based on a signal output from the encoder of the rotation driver 31 and a detection signal output from the notch detector 34 (the light receiving element 34b), the position of the notch in the substrate W held by the rotation holder 33 can be identified. A reflective photoelectric sensor can be used as the notch detector 34.

The pattern detector 35 of the present example is a camera capable of picking an image of the upper surface of the substrate W. The pattern detector 35 picks up an image of the entire upper surface of the substrate W. Thus, image data representing the upper surface of the substrate W is output from the pattern detector 35. As described above, a plurality of circuit patterns are formed on the upper surface of the substrate W carried into the substrate processing apparatus 9 in the present embodiment. Therefore, according to the image data output from the pattern detector 35, the valid area and the invalid area of the substrate W held by the rotation holder 33 can be identified.

The substrate rotator 3 works to identify the position of the notch basically in regard to the substrate W before the coating process is performed by the coating processor 1. Also, the work for identification of the valid area and the invalid area is performed. Furthermore, the work for adjustment of the rotation position of the substrate W is performed. The work for adjustment of the rotation position of the substrate W will be described below.

The receiver-transferer 2 includes a base 21, an articulated arm 22 and a hand 23. The hand 23 is configured to be capable of holding the substrate W. The articulated arm 22 is configured to be capable of advancing and retreating the hand 23 in one direction in a horizontal plane. The base 21 supports the articulated arm 22 such that the articulated arm 22 is liftable and lowerable, and rotatable in a horizontal plane. Further, in the base 21, a plurality of drivers for lifting and lowering the articulated arm 22 and rotating the articulated arm 22 are incorporated as a receiving-transferring driver 24 of Fig. 8, described below. The substrate rotator 3 receives and transfers the substrate W with respect to the coating processor 1.

The control device 4 controls the coating processor 1, the receiver-transferer 2 and the substrate rotator 3. The operation unit 51 and the display 52 are connected to the control device 4. Details of the control device 4 will be described below.

### <2> Details of Structure and Work of Coating Processor 1

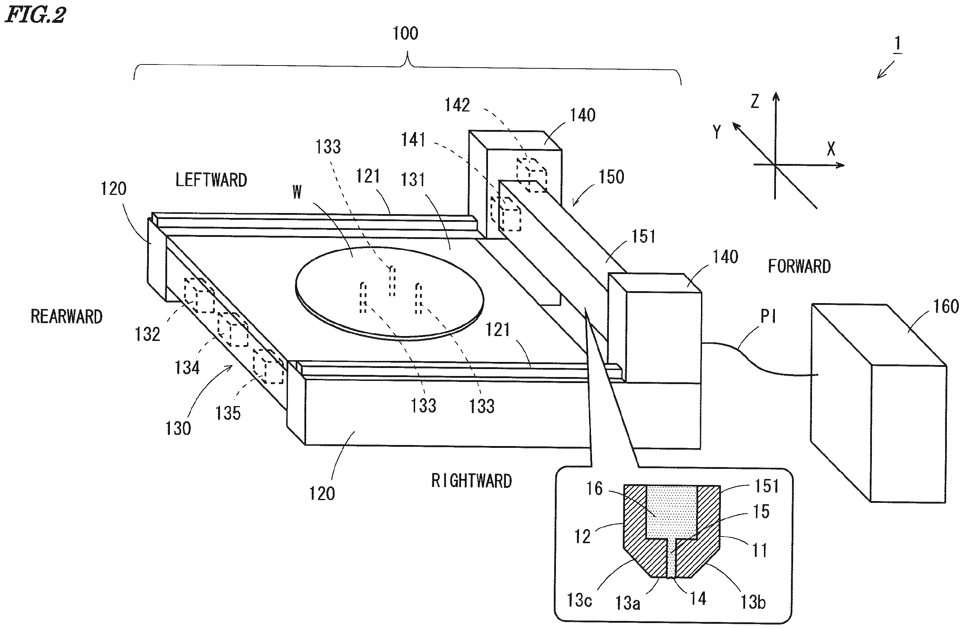

Fig. 2 is an external perspective view of the coating processor 1 of Fig. 1. As shown in Fig. 2, the coating processor 1 includes the coating device 100 and a processing liquid supply system 160.

The coating device 100 includes two stage supports 120, a stage device 130, two nozzle supports 140 and a nozzle device 150. Each of the two stage supports 120 of the coating device 100 has a substantially cuboid shape extending in one direction, and is provided on the installation surface of the substrate processing apparatus 9 (not shown) so as to extend in the X direction. The two stage supports 120 are arranged side by side in the Y direction. A guide rail 121 is provided on the upper surface of each stage support 120.

The stage device 130 is located between the two stage supports 120 in the Y direction and is supported by the two stage supports 120. The stage device 130 includes a plate member 131, a plate adjuster 132, a plurality (three in the present example) of support pins 133, a pin lifting-lowering driver 134 and an intake driver 135.

The plate member 131 is formed of a stone material having a rectangular flat plate shape, for example, and constitutes an upper surface portion of the stage device 130. The substrate W to be processed is placed on part of the plate member 131. In the portion of the plate member 131 on which the substrate W is to be placed (hereinafter referred to as a substrate placement portion), a plurality of intake holes and a plurality of pin insertion holes (not shown) are formed so as to penetrate the plate member 131 in the Z direction.

The plate adjuster 132, the plurality of support pins 133, the pin lifting-lowering driver 134 and the intake driver 135 are provided below the plate member 131. The plate adjuster 132 includes a heater or the like and adjusts the temperature of the substrate placement portion of the plate member 131.

The plurality of support pins 133 are supported by the pin lifting-lowering driver 134 so as to extend in the Z direction and overlap with the plurality of pin insertion holes of the substrate placement portion in a plan view. The pin lifting-lowering driver 134 moves the plurality of support pins 133 in the Z direction. Thus, the upper end portions of the plurality of support pins 133 are moved between a pin lifted position higher than the plate member 131 and a pin lowered position lower than the plate member 131 through the plurality of pin insertion holes.

When the substrate W is transferred from the receiver-transferer 2 to the coating processor 1 in Fig. 1, the upper end portions of the plurality of support pins 133 are held at the pin lifted position. In this state, the substrate W is placed on the plurality of support pins 133. On the other hand, when the substrate W is carried out from the substrate processing apparatus 9, with the upper end portions of the plurality of support pins 133 located at the pin lifted position, the substrate W supported on the plurality of support pins 133 is received by the transport device (not shown). Further, during the coating process for the substrate W in the coating device 100, with the upper end portions of the plurality of support pins 133 at the pin lowered position, the processing liquid is supplied to the substrate W placed on the substrate placement portion of the plate member 131.

The plurality of intake holes formed in the plate member 131 are connected to exhaust equipment or the like of a factory through the intake driver 135 and an intake system (not shown). Based on the control of the controller 110, the intake driver 135 switches an intake path formed between the plurality of intake holes and the intake system, between a communication state and a blocked state. With such a configuration, with the substrate W placed on the substrate placement portion of the plate member 131, the intake driver 135 can cause the substrate W to be held by suction at the substrate placement portion by bringing the intake path into the communication state. Further, with the substrate W held by suction at the substrate placement portion, the intake driver 135 can release the substrate W from the plate member 131 by bringing the intake path into the blocked state.

The two nozzle supports 140 are respectively provided on the upper surfaces of the two stage supports 120. The two nozzle supports 140 are arranged side by side in the Y direction. Each of the two nozzle supports 140 is movable in the X direction along the guide rail 121 of the stage support 120 at which the nozzle support 140 is provided.

The nozzle device 150 is located between the two nozzle supports 140 and supported by the two nozzle supports 140. In at least one of the two nozzle supports 140, an X-direction driver 141 and a Z-direction driver 142 are incorporated.

The nozzle device 150 includes a nozzle block 151. The nozzle block 151 has a substantially cuboid shape extending in one direction. Both end portions of the nozzle block 151 are respectively supported by the two nozzle supports 140. In Fig. 2, the longitudinal cross-sectional view of a lower half portion of the nozzle block 151 (the cross-sectional view of the lower half portion of the nozzle block 151 taken along the vertical plane orthogonal to the Y direction) is shown in the balloon. As shown in the longitudinal cross sectional view, the nozzle block 151 has a front surface 11 directed forwardly of the coating device 100 and a rear surface 12 directed rearwardly of the coating device 100.

Further, the nozzle block 151 has a substrate facing surface 13a, a front inclined surface 13b and a rear inclined surface 13c. In a side view in which the nozzle block 151 is viewed in the Y direction, the front inclined surface 13b extends rearwardly and downwardly from the lower end portion of the front surface 11. On the other hand, in a side view in which the nozzle block 151 is viewed in the Y direction, the rear inclined surface 13c extends forwardly and downwardly from the lower end portion of the rear surface 12. The substrate facing surface 13a connects the lower end portion of the front inclined surface 13b to the lower end portion of the rear inclined surface 13c. A slit-like discharge port 14 is formed in the substrate facing surface 13a. The discharge port 14 extends in the Y direction.

A liquid flow path 15 and a storage 16 are formed in the nozzle block 151. The storage 16 is formed to be capable of storing a certain amount of the processing liquid. The liquid flow path 15 is formed from the storage 16 to the discharge port 14. Thus, the inner space of the storage 16 communicates with the space below the nozzle block 151 (the outer space of the nozzle block 151) through the liquid flow path 15 and the discharge port 14. A pipe PI that forms part of the processing liquid supply system 160 is connected to the nozzle block 151.

The X-direction driver 141 includes an actuator such as a motor, and moves the nozzle supports 140 in the X direction on the guide rails 121 of the stage supports 120. The Z-direction driver 142 includes an actuator such as a motor, and moves the nozzle device 150 supported by the nozzle supports 140 in the Z direction.

The processing liquid supply system 160 includes a processing liquid supply source and fluid-related elements including one or a plurality of pipes, joints, valves and the like, in addition to the above-mentioned pipe PI, and supplies the processing liquid into the storage 16 of the nozzle block 151.

In the coating processor 1, the substrate W is held by suction on the plate member 131 by suction during the coating process. In this state, the nozzle block 151 is brought close to the upper surface of the substrate W, and the nozzle device 150 is moved in the space above the substrate W from a position farther forward than the coating processor 1 toward a position farther rearward than the coating processor 1. At this time, the position (height position) of the nozzle device 150 in the Z direction is adjusted such that the processing liquid in the nozzle block 151 is drawn (discharged) from the discharge port 14 to the gap between the nozzle block 151 and the substrate W due to capillary action. In this manner, a method of supplying the coating liquid onto the substrate W from the discharge port of the nozzle by utilizing capillary action is referred to as a capillary coating method.

### <3> Series of Works in Substrate Processing Apparatus 9

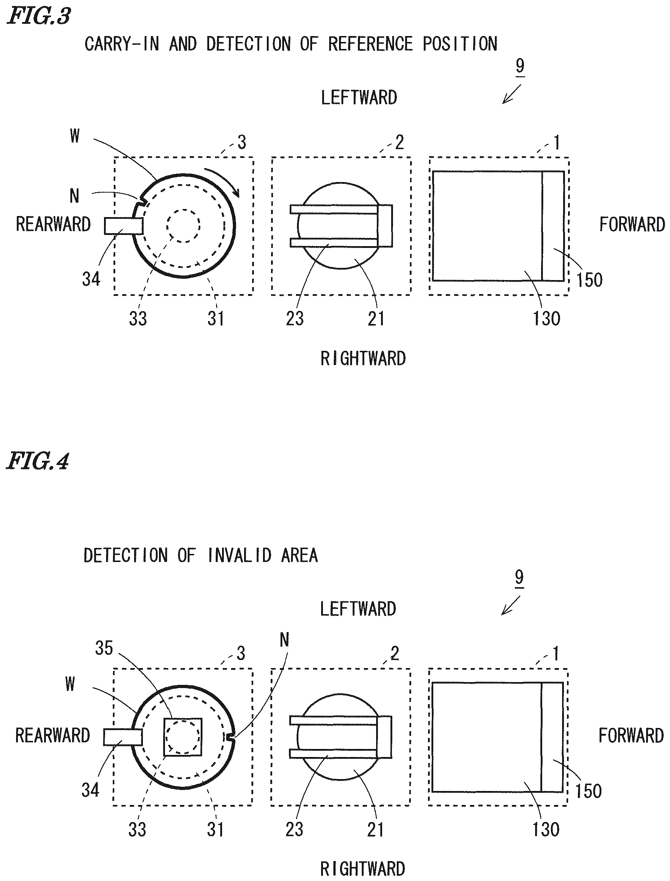

Figs. 3 to 6 are schematic plan views for explaining a series of works in the substrate processing apparatus 9 of Fig. 1. In Figs. 3 to 6, the working states of the substrate processing apparatus 9 of Fig. 1 are shown in a chronological order in four plan views.

As shown in Fig. 3, the substrate W to be carried into the substrate processing apparatus 9 of Fig. 1 is first placed on the rotation holder 33 of the substrate rotator 3 and is held by suction by the rotation holder 33. In this state, the substrate W is rotated substantially once, and the position of the notch N in the outer peripheral end of the substrate W is identified based on a signal output from the encoder of the rotation driver 31 of Fig. 1 and a detection signal output from the notch detector 34. That is, in the substrate rotator 3, it is identified which orientation (forward, rearward, rightward and leftward, for example) in the substrate processing apparatus 9 the notch N of the substrate W held by suction by the rotation holder 33 is oriented.

Next, as shown in Fig. 4, the rotation position of the substrate W is adjusted such that the notch N of the substrate W is oriented in a predetermined reference orientation (forward in the present example). The rotation position of the substrate W represents an amount of rotation (rotation angle) of the substrate W when the substrate W is rotated in a horizontal plane, with the state of the substrate W when the notch N is oriented in the reference orientation in a plan view as a reference.

Thereafter, with the notch N oriented in the reference orientation, an image of the entire upper surface of the substrate W is picked up by the pattern detector 35. Thus, based on the image data output from the pattern detector 35, an invalid area on the upper surface of the substrate W is identified, and invalid area information is generated as identification result data representing the invalid area of the substrate W. In the invalid area information, the invalid area on the upper surface of the substrate W is defined with the notch N as a reference.

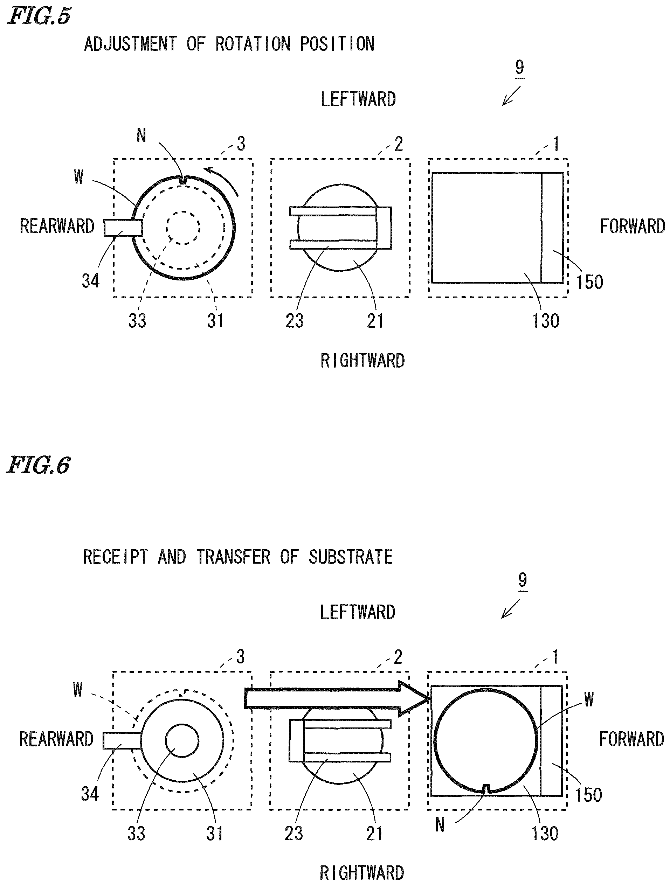

Next, as shown in Fig. 5, the rotation position of the substrate W is adjusted by rotation or non-rotation of the rotation holder 33. In the example of Fig. 5, the rotation position of the substrate W is adjusted such that the notch N is oriented leftwardly. The purpose and reason for the adjustment of the rotation position will be described below.

Next, the suction state of the substrate W by the rotation holder 33 is released in the substrate rotator 3. In this state, as shown in Fig. 6, the substrate W on the rotation holder 33 is received by the hand 23 of the receiver-transferer 2 and transferred to the coating processor 1. In the coating processor 1, the substrate W is placed on the stage device 130 (plate member 131) and held by suction.

The receiving-transferring work for the substrate W by the receiver-transferer 2 is performed in more detail as follows. First, the hand 23 of the receiver-transferer 2 is moved rearwardly from a position (home position) substantially at the center of the base 21 in a plan view, so that the substrate W on the rotation holder 33 is received by the hand 23. Thereafter, the hand 23 retreats to the home position, and the orientation of the hand 23 is rotated by 180° in a horizontal plane. Subsequently, the hand 23 is moved forwardly from the home position, so that the substrate W on the hand 23 is placed on the stage device 130 of the coating processor 1.

With such work of the receiver-transferer 2, the rotation position of the substrate W placed on the stage device 130 of the substrate rotator 3 is mispositioned by 180° with respect to the substrate W supported on the rotation holder 33 in the substrate rotator 3. Thus, in the example of Fig. 6, the notch N (see Fig. 5) oriented leftwardly in the substrate rotator 3 before the receipt and transfer by the receiver-transferer 2 is oriented rightwardly in the coating processor 1 after the receipt and transfer.

Thereafter, the coating process is performed on the substrate W placed on the stage device 130 in the coating processor 1. The substrate W is carried out from the coating processor 1 by the transport device (not shown) after the coating process and is transported to another substrate processing apparatus outside of the substrate processing apparatus 9, for example.

### <4> Adjustment of Rotation Position of Substrate W in Substrate Rotator 3

In the following description, a portion in which the thickness of a film locally changes on the substrate W after the coating process is referred to as an abnormal film-thickness portion. As described in the background art, in a coating processing device using a slit nozzle, the slit nozzle is separated from a substrate at the end of a coating process, so that an abnormal film-thickness portion may be generated on the substrate.

The position of the above-mentioned abnormal film-thickness portion can be predicted to some extent in consideration of the mechanism of the coating process. That is, in the coating processor 1 according to the present embodiment, the nozzle block 151 is moved rearwardly with respect to the substrate W placed on the stage device 130, so that a film of the processing liquid is formed on the substrate W. Therefore, it can be predicted that the substrate W held by suction on the stage device 130 in the coating processor 1 of the present example is likely to have an abnormal film-thickness portion in the rear end portion of the substrate W (the rear end portion of the substrate W in the forward-and-rearward direction of the substrate processing apparatus 9). Further, the shape and size of the abnormal film-thickness portion generated in the rear end portion of the substrate W in the coating processor 1 can also be predicted to some extent.

In the meantime, in a case in which an abnormal film-thickness portion is located in an invalid area, that is, a case in which the abnormal film-thickness portion is located outside of a valid area, it is considered that the abnormal film-thickness portion is unlikely to adversely affect the valid area in the subsequent process for the substrate W. Therefore, in the substrate processing apparatus 9 according to the present embodiment, the invalid area on the substrate W is identified by the substrate rotator 3 before the coating process is performed by the coating processor 1. Further, in consideration of invalid area information representing an identification result and the shape and size of an abnormal film-thickness portion predicted in advance, one or a plurality of portions in which an abnormal film-thickness portion can be arranged in an invalid area are extracted.

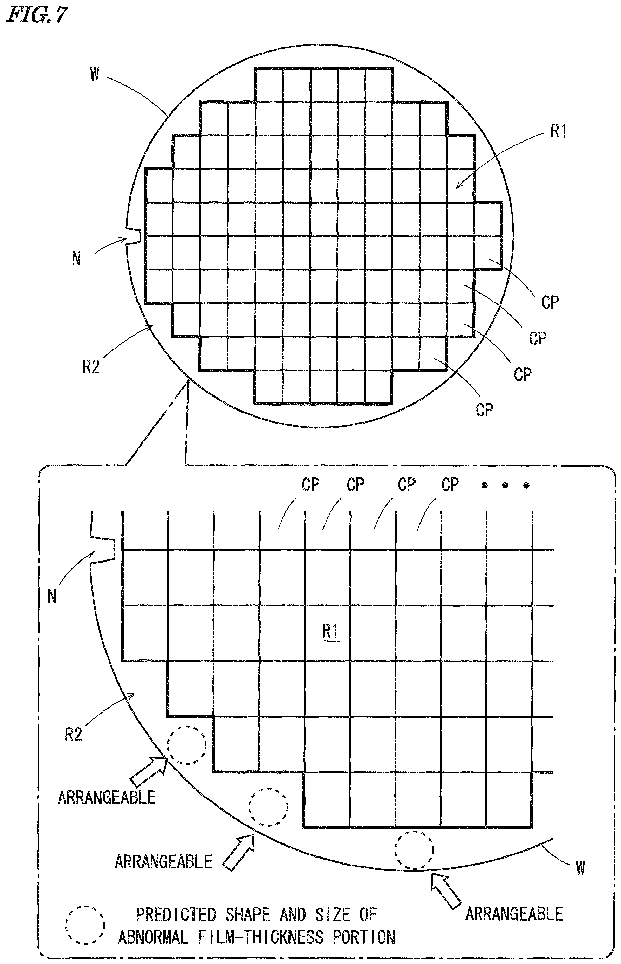

Fig. 7 is a diagram for explaining extraction of portions in which abnormal film-thickness portions can be arranged from an invalid area on the substrate W. Fig. 7 shows a plan view of the entire upper surface of the substrate W and a partially enlarged plan view of the upper surface of the substrate W in a balloon.

As shown in Fig. 7, on the upper surface of the substrate W of the present example, a plurality of circuit patterns CP are arranged in a matrix except for a partial area including the outer peripheral end of the substrate W. An area in which the plurality of circuit patterns CP are formed is a valid area R1. On the other hand, an area excluding the valid area R1 in the upper surface of the substrate W is an invalid area R2. In Fig. 7, the boundary portion between the valid area R1 and the invalid area R2 is indicated by a thick solid line.

The invalid area R2 surrounds the entire valid area R1. However, as shown in the balloon of Fig. 7, the invalid area R2 does not have an annular shape in which an inner edge and an outer edge are formed of smooth concentric circles. In the direction extending along the outer peripheral end of the substrate W, the width of the invalid area R2 in a radial direction of the substrate W in a plurality of portions are different from one another in accordance with the shape of the outer edge of the valid area R1.

Therefore, as indicated by the dotted circles in the balloon of Fig. 7, in consideration of the predicted shape and size of an abnormal film-thickness portion, a portion in which abnormal film-thickness portions can be arranged is limited to part of the invalid area R2. In the example of Fig. 7, when being arranged in a portion in which the notch N is formed and its peripheral portions in the invalid area R2, an abnormal film-thickness portion is at least partially located in the valid area R1.

As described above, with the substrate W held by suction by the rotation holder 33 of the substrate rotator 3, one or a plurality of portions in which an abnormal film-thickness portion can be arranged in the invalid area R2 are extracted. Thereafter, the rotation position of the substrate W is adjusted such that one of the one or plurality of extracted portions is located in the rear end portion of the substrate W on the stage device 130 of the substrate rotator 3. In the following description, the rotation position of the substrate W when the one extracted portion of the invalid area R2 is located in the rear end portion of the substrate W on the stage device 130 of the substrate rotator 3 is referred to as a target rotation position.

In the substrate processing apparatus 9 of the present example, the rotation position of the substrate W is mispositioned by 180° when the substrate W is received from the substrate rotator 3 to be transferred to the coating processor 1 by the receiver-transferer 2. Therefore, more specifically, in the substrate rotator 3 of the present example, the rotation position of the substrate W is adjusted to be mispositioned by 180° with respect to the target rotation position immediately before the substrate W is received and transferred by the receiver-transferer 2.

### <5> Control System of Substrate Processing Apparatus 9

Fig. 8 is a block diagram showing the configuration of a control system of the substrate processing apparatus 9 of Fig. 1. As described above, the substrate processing apparatus 9 includes the control device 4. The control device 4 includes a CPU (Central Processing Unit), a RAM (Random Access Memory), a ROM (Read Only Memory) and a storage device. The RAM is used as a work area for the CPU. The ROM stores a system program. The storage device stores a coating processing program for performing the coating process on the substrate W. Further, the storage device stores a position adjustment program for adjusting the rotation position of the substrate W.

As shown in Fig. 8, the control device 4 includes a coating controller 410, a receiving-transferring controller 420, a position identifier 431, a pattern acquirer 432, a position determiner 433, a chuck controller 434, a storage 435, a receiver 451 and a display controller 452 as functions for controlling the work of each component of the substrate processing apparatus 9. Various functions of the control device 4 are implemented by execution of the coating processing program and the position adjustment program stored in the storage device on the RAM by the CPU. Part or all of the functions of the control device 4 may be implemented by hardware such as an electronic circuit.

The substrate W is transferred from the substrate rotator 3, so that the coating controller 410 controls the X-direction driver 141, the Z-direction driver 142, the plate adjuster 132, the pin lifting-lowering driver 134, the intake driver 135, and the processing liquid supply system 160 of the coating processor 1. Thus, the coating process is performed with use of the capillary coating method on the substrate W held by suction at the target rotation position on the stage device 130.

The receiver-transferer 2 includes the receiving-transferring driver 24. The receiving-transferring driver 24 includes a plurality of drivers related to the work of the articulated arm 22 of Fig. 1. The receiving-transferring controller 420 controls the receiving-transferring driver 24. Thus, the substrate W placed on the rotation holder 33 of the substrate rotator 3 is received by the hand 23 of the receiver-transferer 2 and transferred onto the stage device 130 of the coating processor 1.

Thus, the position identifier 431 identifies the position of the notch N in the substrate W held by the rotation holder 33 based on a signal output from the encoder of the rotation driver 31 and a detection signal output from the notch detector 34 (the light receiving element 34b).

The pattern acquirer 432 controls the pattern detector 35 such that an image of the upper surface of the substrate W is picked up with the notch N of the substrate W held by the rotation holder 33 is oriented in the reference orientation. Further, the pattern acquirer 432 identifies the valid area R1 and the invalid area R2 on the upper surface of the substrate W based on the image data of the upper surface of the substrate W output from the pattern detector 35. Further, the pattern acquirer 432 generates invalid area information representing the invalid area R2.

In advance, the storage 435 stores information in regard to the shape and size of an abnormal film-thickness portion which is predicted to be generated in the substrate W after the coating process as abnormal portion information. Based on the invalid area information generated by the pattern acquirer 432 and the abnormal portion information stored in the storage 435, the position determiner 433 extracts one or a plurality of portions in which an abnormal film-thickness portion can be arranged in the invalid area R2. After that, the position determiner 433 determines the target rotation position such that one of the one or plurality of extracted portions is located in the rear end portion of the substrate W in the stage device 130. The determined target rotation position is stored in the storage 435.

The substrate rotator 3 includes the intake device 36 connected to the intake path of the rotation holder 33. In a case in which the substrate W is placed on the rotation holder 33, the chuck controller 434 controls the intake device 36 such that the substrate W is held by suction on the rotation holder 33. Thereafter, when the position of the notch N is identified, the chuck controller 434 controls the rotation driver 31 to rotate the rotation holder 33 about once.

Further, the chuck controller 434 rotates the rotation holder 33 such that the notch N is oriented in the reference orientation, by controlling the rotation driver 31 based on the identification result provided by the position identifier 431 before the pattern detector 35 picks up an image of the upper surface of the substrate W.

Further, the chuck controller 434 adjusts the rotation position of the substrate W by controlling the rotation driver 31 based on the determined target rotation position after the target rotation position is determined by the position determiner 433. Further, the chuck controller 434 controls the intake device 36 to release the holding state of the substrate W in the rotation holder 33 after the adjustment of the rotation position of the substrate W.

The operation unit 51 includes a keyboard and a pointing device, for example, and is configured to be operable by a user. The user can input abnormal portion information by operating the operation unit 51. In this case, the receiver 451 receives the abnormal portion information input by the user and stores the input abnormal portion information in the storage 435. Further, in a case in which abnormal portion information is stored in the storage 435 in advance, the receiver 451 updates the abnormal portion information stored in the storage 435 with the input abnormal portion information. In the present embodiment, abnormal portion information is preferably created based on an experiment or simulation, for example.

Further, the user can also input a target rotation position by operating the operation unit 51. In this case, the receiver 451 receives the target rotation position input by the user, and stores the input target rotation position in the storage 435. Further, in a case in which a target rotation position is already stored in the storage 435, the receiver 451 updates the target rotation position stored in the storage 435 with the input target rotation position. Thus, the user can set a desired target rotation position without depending on a process performed by the position determiner 433.

The display 52 includes a liquid crystal display device or an organic EL display device, for example. The display controller 452 causes the display 52 to display various information such as a target rotation position and abnormal portion information stored in the storage 435. Thus, the user can reset the abnormal portion information and the target rotation position while viewing various information in regard to the coating process for the substrate W.

### <6> One Example of Series of Processes Performed by CPU of Control Device 4

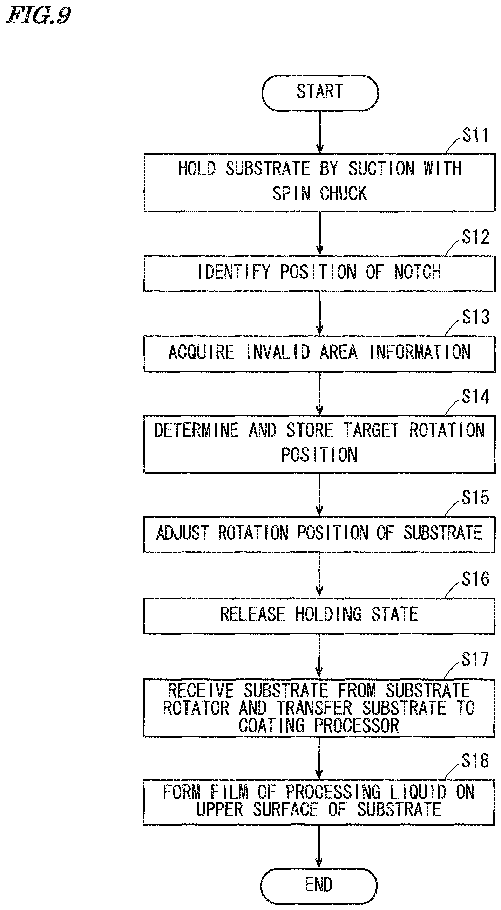

Fig. 9 is a flowchart showing one example of a series of processes performed by the CPU of the control device 4. A series of processes described below are performed by execution of the coating processing program and the position adjustment program stored in the storage device by the CPU.

First, the substrate W to be carried into the substrate processing apparatus 9 is placed on the rotation holder 33 of the substrate rotator 3. In this state, the chuck controller 434 of Fig. 8 controls the intake device 36 of the substrate rotator 3 such that the substrate W is held by suction on the rotation holder 33 (step S11).

Next, the position of the notch N in the substrate W held by the rotation holder 33 is identified (step S12). Specifically, the chuck controller 434 of Fig. 8 controls the rotation driver 31 to rotate the substrate W about once. At this time, the position identifier 431 of Fig. 8 identifies the position of the notch N in the substrate W held by the rotation holder 33 based on a signal output from the encoder of the rotation driver 31 and a detection signal output from the notch detector 34 (the light receiving element 34b).

Next, invalid area information representing an invalid area of the substrate W held by the rotation holder 33 is acquired (step S13). Specifically, the chuck controller 434 of Fig. 8 rotates the rotation holder such that the notch N is oriented in the reference orientation, by controlling the rotation driver 31 based on the position of the notch N identified in the step S12. Thereafter, the pattern acquirer 432 of Fig. 8 controls the pattern detector 35 such that an image of the upper surface of the substrate W is picked up. Further, the pattern acquirer 432 identifies the valid area R1 and the invalid area R2 in the upper surface of the substrate W based on the image data of the upper surface of the substrate W output from the pattern detector 35. Further, the pattern acquirer 432 generates invalid area information representing the identified invalid area R2.

Next, the target rotation position is determined, and the determined target rotation position is stored in the storage 435 (step S14). Specifically, the position determiner 433 of Fig. 8 extracts one or a plurality of portions in which an abnormal film-thickness portion can be arranged in the invalid area R2 based on the invalid area information acquired in the step S13 and the abnormal portion information stored in advance in the storage 435. After that, the position determiner 433 determines a target rotation position such that one of the one or plurality of extracted portions is located in the rear end portion of the substrate W in the stage device 130. The determined target rotation position is stored in the storage 435.

Next, the chuck controller 434 controls the rotation driver 31 and adjusts the rotation position of the substrate W such that the substrate W is placed at the determined target rotation position on the stage device 130 of the coating processor 1 (step S15).

Next, the chuck controller 434 controls the intake device 36 of the substrate rotator 3 to release the holding state of the substrate W in the rotation holder 33 (step S16).

Next, the receiving-transferring controller 420 of Fig. 8 controls the receiving-transferring driver 24 of the receiver-transferer 2 to receive the substrate Won the rotation holder 33 and transfer the substrate W onto the stage device 130 of the coating processor 1 (step S17). Finally, the coating controller 410 of Fig. 8 controls each constituent element of the coating processor 1 to form a film of the processing liquid on the upper surface of the substrate W (step S18), and the process ends.

### <7> Effects

(a) In the above-mentioned substrate processing apparatus 9, before a film of the processing liquid is formed on the substrate W with use of the nozzle block 151 having the slit-like discharge port 14, the invalid area R2 in the upper surface of the substrate W is identified, and the invalid area information is generated. Based on the generated invalid area information and a position at which an abnormal film-thickness portion is predicted to be generated, the target rotation position is determined. The rotation position of the substrate W is adjusted by the substrate rotator 3 such that the substrate W is placed on the target rotation position on the stage device 130 of the coating processor 1. Thus, the abnormal film-thickness portion can be located in the invalid area R2 in the upper surface of the substrate W. As a result, a processing defect of the substrate W caused by the process of applying the processing liquid is reduced.
(b) Further, in the above-mentioned substrate processing apparatus 9, the invalid area information is created based on the image data obtained when an image of the substrate W is picked up. This enables adjustment of the rotation position of the substrate Wwith high reliability.
(c) In the substrate processing apparatus 9 according to the present embodiment, the substrate rotator 3 and the receiver-transferer 2 are used to adjust the rotation position of the substrate W placed on the stage device 130. Thus enables adjustment of the rotation position of the substrate W with a simple configuration and high reliability.

### 2. Second Embodiment

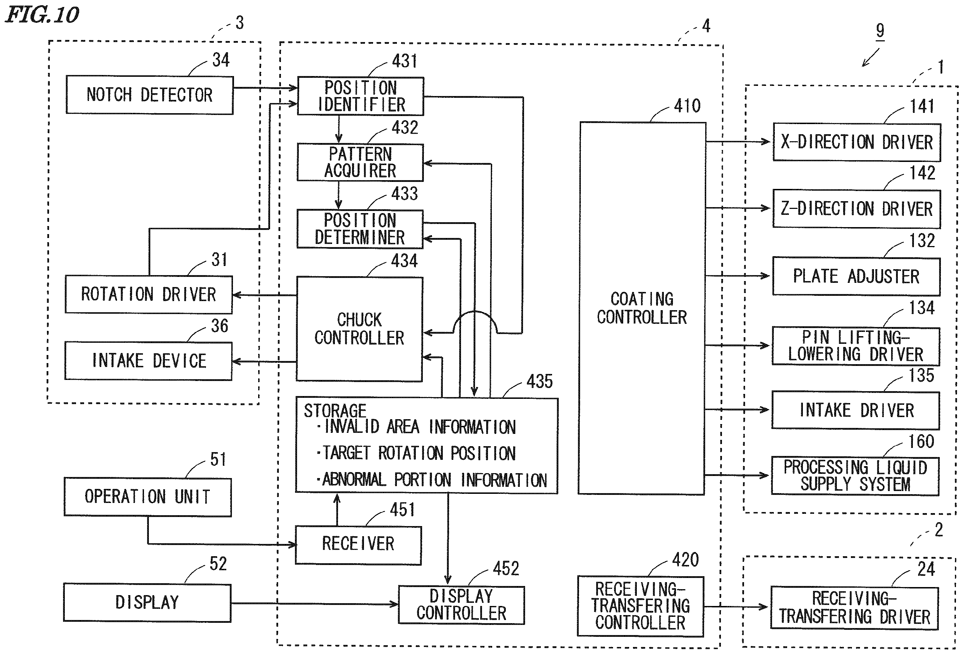

Differences of a substrate processing apparatus 9 according to a second embodiment from the substrate processing apparatus 9 according to the first embodiment will be described. Fig. 10 is a block diagram showing the configuration of the control system of the substrate processing apparatus 9 according to the second embodiment.

It is considered that the information in regard to a valid area R1 and an invalid area R2 in one substrate W is known to some extent in consideration of the history of a process for the one substrate W, the set dimensions of a circuit pattern CP fabricated in the one substrate W, or the like. Therefore, invalid area information for one substrate W can be predicted in advance with high accuracy.

As such, in the present embodiment, it is assumed that one or a plurality of invalid area information pieces respectively corresponding to one or a plurality of types of substrates W are created in consideration of the history of a process for various substrates W, the set dimensions of a circuit pattern CP, or the like. Further, it is assumed that the one or plurality of created invalid area information pieces are stored in the storage 435. Therefore, in the substrate processing apparatus 9 according to the present embodiment, the substrate rotator 3 does not have the pattern detector 35 of Fig. 6.

In the present preferred embodiment, before a process for the one substrate W is performed in the substrate processing apparatus 9, the information in regard to the type of the one substrate W is input in advance by a user operation of the operation unit 51. In this case, the receiver 451 receives the input type of the substrate W and stores the information representing the type in the storage 435.

Thus, the pattern acquirer 432 acquires the invalid area information piece corresponding to the input type of the substrate W from the one or plurality of invalid area information pieces stored in advance in the storage 435. Thereafter, based on the invalid area information piece acquired by the pattern acquirer 432, the position determiner 433 determines a target rotation position. As described above, the invalid area information is defined with the notch N as a basis.

In the substrate processing apparatus 9 according to the present embodiment, it is not necessary to provide the configuration (camera or the like) for actually detecting the invalid area R2 of the substrate W to be processed. Therefore, it is possible to appropriately adjust the rotation position of the substrate W while suppressing an increase in number of components.

In a case in which invalid area information is created in consideration of the set dimensions of a circuit pattern CP with respect to the substrate W, a plurality of circuit patterns CP do not have to be formed on the substrate W to be carried into the substrate processing apparatus 9. Therefore, it is possible to effectively use the substrate processing apparatus 9 for a coating process for a bare wafer on which a circuit pattern CP or various films are not formed.

### 3. Other Embodiments

(a) While a camera that can pick up an image of the upper surface of the substrate W is used as the pattern detector 35 in order to acquire invalid area information of the substrate W in the substrate processing apparatus 9 according to the first embodiment, the present disclosure is not limited to this.

A camera that can pick up an image of part of the upper surface of the substrate W may be used as the pattern detector 35. In this case, the substrate W may be rotated such that the imaging field of view of the camera passes through the entire upper surface of the substrate W. Thus, by combining image data pieces that change in a chronological order, it is possible to generate the image data of the entire upper surface of the substrate W.

Further, as the pattern detector 35, a film-thickness measurement device that measures the thicknesses of a film formed on the upper surface of the substrate W may be used instead of a camera. In this case, the thicknesses of a film of a plurality of portions on the upper surface of the substrate W held by the rotation holder 33 are measured. Thus, based on the distribution of the film-thickness in the upper surface of the substrate W, an area in which a plurality of circuit patterns CP are formed in the upper surface of the substrate W may be identified.

Further, an invalid area R2 is basically located in the outer peripheral end of the substrate W and its vicinity. Therefore, the pattern detector 35 may include a camera capable of picking up an image of only a portion in the vicinity of the outer peripheral end of the substrate W. Alternatively, the pattern detector 35 may include a film-thickness measurement device capable of measuring the film-thickness of a portion in the vicinity of the outer peripheral end of the substrate W.

(b) In a case in which a process is successively performed on a plurality of substrates W of the same type in the substrate processing apparatus 9 according to the first embodiment, invalid area information acquired during the process for the first substrate W may be commonly used for the process for the second and subsequent substrates W. In this case, it is not necessary to pick up an image of the substrate W with use of the pattern detector 35 during a process for each of the second and subsequent substrates W.

In this case, the substrate W on which the coating process is performed first may be returned from the coating processor 1 to the substrate rotator 3, and an image of the upper surface of the substrate W may be picked up again by the pattern detector 35. Further, the shape and size of an abnormal film-thickness portion may be measured based on the image data of the substrate W after the coating process, and abnormal portion information may be corrected or updated based on a result of measurement. This improves the reliability of the abnormal portion information.

(c) While the rotation position of the substrate W is adjusted assuming that an abnormal film-thickness portion is likely to be generated only in the rear end portion of the substrate W during the coating process in the coating processor 1 in the substrate processing apparatus 9 according to the first and second embodiments, the present disclosure is not limited to this.

In a case in which the coating process is performed on the substrate W with use of the nozzle block 151 having the slit-like discharge port 14, an abnormal film-thickness portion may also be generated at the start of the coating process, that is, the time when the processing liquid first comes into contact with the substrate W. In view of this point, it can be said that an abnormal film-thickness portion is likely to be generated not only in the rear end portion of the substrate W but also in the front end portion of the substrate W.

Therefore, in a case in which a plurality of portions in which abnormal film-thickness portions can be arranged in the invalid area R2 are extracted in regard to the one substrate W, whether there are two portions opposite to each other across the center of the substrate W among the plurality of extracted portions may be identified. Further, in a case in which there are two portions opposite to each other across the center of the substrate W among the extracted plurality of portions, the rotation position of the substrate W is adjusted such that the two portions are respectively located in the front end portion and the rear end portion of the substrate Won the stage device 130 of the substrate rotator 3. Thus, even in a case in which abnormal film-thickness portions are generated in two portions in the outer peripheral end of the substrate W, a processing defect of the substrate W caused by the abnormal film-thickness portions is reduced.

(d) While the receiver-transferer 2 and the substrate rotator 3 are used to adjust the rotation position of the substrate W placed on the stage device 130 and held by suction in the substrate processing apparatus 9 according to the first and second embodiments, the present disclosure is not limited to this. For example, the configuration for identifying the position of the notch N of the substrate W and adjusting the rotation position of the substrate W may be provided on the stage device 130 of the coating processor 1. In this case, the receiver-transferer 2 or the substrate rotator 3 is not required, and a reduction in size of the substrate processing apparatus 9 is realized.

(e) While the processing liquid is supplied onto the substrate W from the nozzle block 151 with use of capillary action that occurs in the gap between the nozzle block 151 and the substrate W in the substrate processing apparatus 9 according to the first and second embodiments, the present disclosure is not limited to this.

For example, the substrate processing apparatus 9 may be configured to supply the processing liquid onto the substrate W from the discharge port 14 of the nozzle block 151 without utilizing an occurrence of capillary action. In this case, when the processing liquid is supplied from the nozzle block 151 to the substrate W, the distance between the nozzle block 151 and the substrate W can be increased to such an extent that capillary action does not occur.

In this case, the processing liquid is supplied from the nozzle block 151 to the substrate W by adjustment (an increase) of the pressure of the processing liquid in the nozzle block 151. When the nozzle block 151 is moved with respect to the substrate W, an opening width of the discharge port 14 is preferably adjusted to match the dimension of the substrate W such that an excess processing liquid is not discharged to the outer area of the substrate W. That is, it is preferable to close a portion not overlapping with the substrate W in a plan view in the discharge port 14. Thus, the processing liquid is prevented from being discharged to an area in which the substrate W is not present, and wasteful consumption of the processing liquid is prevented.

(f) While a film of the processing liquid is formed on the substrate W by movement of the nozzle device 150 in the forward-and-rearward direction with respect to the substrate W on the fixed plate member 131 in the coating device 100 according to the first and second embodiments, the present disclosure is not limited to this.

The coating device 100 may be configured such that the plate member 131 is movable in the forward-and-rearward direction. In this case, a film of the processing liquid may be formed on the substrate W placed on the plate member 131 by movement of the plate member 131 in the forward-and-rearward direction with respect to the fixed nozzle device 150. Alternatively, a film of the processing liquid may be formed on the substrate W placed on the plate member 131 by rearward movement of the nozzle device 150 and forward movement of the plate member 131.

A direction of the relative movement of the nozzle device 150 and the plate member 131 during the coating process may be opposite to that of the example of the above-mentioned embodiment. For example, a film of the processing liquid may be formed on the substrate W by forward movement of the nozzle device 150 with respect to the plate member 131. In this case, a target rotation position is defined such that a portion in which an abnormal film-thickness portion can be arranged in the invalid area R2 is located in the front end portion of the substrate Won the stage device 130.

(g) While an image of the entire upper surface of the substrate W is picked up by the pattern detector 35 with the notch N oriented in the reference orientation in the substrate processing apparatus 9 according to the above-mentioned first and second embodiments, the present disclosure is not limited to this. An image of the substrate W may be picked up by the pattern detector 35 with the notch N not oriented in the reference orientation. Also in this case, based on the image data acquired by imaging, the positional relationship between the notch N and the valid area R1 can be grasped. Thus, the invalid area information can be generated.

### 4. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the substrate processing apparatus 9 is an example of a substrate processing apparatus, the valid area R1 is an example of a valid area, the invalid area R2 is an example of an invalid area, the stage device 130 of the coating processor 1 is an example of a substrate holder, the Y direction and the leftward-and-rightward direction of the substrate processing apparatus 9 are examples of a first direction, the nozzle block 151 is an example of a nozzle, and the discharge port 14 of the nozzle block 151 is an example of a discharge port of a nozzle.

Further, the X direction and the forward-and-rearward direction of the substrate processing apparatus 9 are examples of a second direction, the nozzle support 140, the X-direction driver 141 and the Z-direction driver 142 of the coating processor 1 are examples of a mover, the pattern acquirer 432 of the control device 4 is an example of an acquirer, the receiver-transferer 2, the substrate rotator 3 and the chuck controller 434 are examples of an adjuster.

Further, the pattern detector 35 is an example of a detector, the storage 435 is an example of a storage, the rotation driver 31, the rotation shaft 32 and the rotation holder 33 of the substrate rotator 3 are examples of a substrate rotator, and the receiver-transferer 2 is an example of a receiver-transferer.

### 5. Overview of Embodiments

(Item 1) A substrate processing apparatus according to item 1 forms a film of a processing liquid on an upper surface of a substrate having an at least partially circular outer periphery, wherein the upper surface of the substrate includes a valid area in which a circuit pattern is formed or to be formed and an invalid area excluding the valid area, and the substrate processing apparatus includes a substrate holder that holds the substrate, a nozzle that has a slit-like discharge port extending in a first direction and discharges the processing liquid from the discharge port to the substrate held by the substrate holder, a mover that performs a relative moving work for relative movement of at least one of the substrate holder and the nozzle with respect to another one in a second direction intersecting with the first direction such that the nozzle passes through a space above the substrate while discharging the processing liquid to the substrate, an acquirer that acquires invalid area information representing the invalid area in the upper surface of the substrate before the relative moving work is performed, and an adjuster that adjusts a rotation position of the substrate held by the substrate holder based on the invalid area information acquired by the acquirer before the relative moving work is performed.

In the substrate processing apparatus, due to the relative moving work of the mover, the nozzle passes through the space above the substrate held by the substrate holder while discharging the processing liquid. Thus, a film of the processing liquid is formed on the upper surface of the substrate held by the substrate holder.

In the film formed on the upper surface of the substrate as described above, a portion in which the thickness changes because of a change in state of the processing liquid between the nozzle and the substrate (hereinafter referred to as an abnormal film-thickness portion) may be generated. The formation of such an abnormal film-thickness portion on the valid area of the upper surface of the substrate adversely affects a subsequent process for the substrate.

With the above-mentioned configuration, invalid area information is acquired before the relative moving work of the mover. Further, a position at which the abnormal film-thickness portion is to be generated in the upper surface of the substrate can be predicted to some extent. Therefore, based on the acquired invalid area information and the position at which the abnormal film-thickness portion is predicted to be generated, the rotation position of the substrate in the substrate holder is adjusted. Thus, the abnormal film-thickness portion can be located in the invalid area of the upper surface of the substrate. As a result, a processing defect of the substrate caused by the process of applying the processing liquid is reduced.

(Item 2) The substrate processing apparatus according to item 1, wherein a circuit pattern may be formed in the valid area of the upper surface of the substrate, the substrate processing apparatus may further include a detector that detects an area in which a circuit pattern is formed in the upper surface of the substrate and detects an area excluding the area in which the circuit pattern is formed as the invalid area before the relative moving work is performed, and the acquirer acquires information of an invalid area detected in regard to the substrate as the invalid area information after the invalid area of the substrate is detected by the detector and before the relative moving work is performed in regard to the substrate.

In this case, before the processing liquid is applied to the substrate, the invalid area of the substrate is detected. Further, the rotation position of the substrate is adjusted based on the information of the actual detected invalid area. This enables adjustment of the rotation angle of the substrate with high reliability.

(Item 3) The substrate processing apparatus according to item 1, may further include a storage that stores one or a plurality of types of invalid area information pieces that are predetermined in correspondence with one or a plurality of types of substrates, wherein the acquirer may acquire an invalid area information piece corresponding to a type of the substrate from among the one or plurality of types of invalid area information pieces stored in the storage before the relative moving work is performed in regard to the substrate.

In this case, it is not necessary to provide the configuration for actually detecting the invalid area of the substrate. Therefore, it is possible to adjust the rotation position of the substrate while suppressing an increase in number of components.

(Item 4) The substrate processing apparatus according to any one of items 1 to 3, wherein the acquirer may be configured to further acquire abnormal portion information representing an abnormal film-thickness portion that is predicted to be generated in a film of the processing liquid formed on the substrate by the relative moving work before the relative moving work is performed, and the adjuster may adjust a rotation position of the substrate held by the substrate holder such that the abnormal film-thickness portion is located in the invalid area based on the invalid area information and the abnormal portion information acquired by the acquirer before the relative moving work is performed.

In this case, the abnormal film-thickness portion generated on the substrate after formation of a film of the processing liquid is located in the invalid area with high probability. Therefore, a processing defect of the substrate caused by the process of applying the processing liquid is more sufficiently reduced.

(Item 5) The substrate processing apparatus according to any one of items 1 to 4, wherein the adjuster may include a substrate rotator configured to change a rotation position of the substrate by rotating the substrate about an axis intersecting with the substrate, and a receiver-transferer that receives the substrate from the substrate rotator and transfer the substrate to the substrate holder.

In this case, the rotation position of the substrate held by the substrate holder can be adjusted with a simple configuration.

(Item 6) The substrate processing apparatus according to any one of items 1 to 5, wherein the mover, during the relative moving work, with a gap having a predetermined length formed between the upper surface of the substrate held by the substrate holder and the nozzle and with the gap filled with the processing liquid, may relatively move at least one of the substrate and the nozzle with respect to another one such that the processing liquid in the nozzle is drawn onto the upper surface of the substrate from the discharge port due to capillary action that occurs in the gap.

In this manner, it is possible to reduce an occurrence of a processing defect of the substrate caused by the coating process while improving the utilization efficiency of the processing liquid by supplying the coating liquid onto the substrate from the discharge port of the nozzle with utilization of capillary action.

(Item 7) A substrate processing method according to item 7 of forming a film of a processing liquid on an upper surface of a substrate having an at least partially circular outer periphery, wherein the upper surface of the substrate includes a valid area in which a circuit pattern is formed or to be formed and an invalid area excluding the valid area, and the substrate processing method includes holding the substrate using a substrate holder, a relative moving step of relatively moving at least one of the substrate holder and the nozzle with respect to another one in a second direction intersecting with a first direction such that a nozzle having a slit-like discharge port extending in the first direction passes through a space above the substrate while discharging the processing liquid from the discharge port to the substrate held by the substrate holder, a relative moving step of relatively moving at least one of the substrate holder and the nozzle with respect to another one in a second direction intersecting with a first direction such that a nozzle having a slit-like discharge port extending in the first direction passes through a space above the substrate while discharging the processing liquid from the discharge port to the substrate held by the substrate holder, acquiring invalid area information representing the invalid area in the upper surface of the substrate before the relative moving step, and adjusting a rotation position of the substrate held by the substrate holder based on the invalid area information acquired in the acquiring before the relative moving step.

With the substrate processing method, the nozzle passes through the space above the substrate held by the substrate holder while discharging the processing liquid in the relative moving step. Thus, a film of the processing liquid is formed on the upper surface of the substrate held by the substrate holder.

In the film formed on the upper surface of the substrate as described above, a portion in which the thickness changes because of a change in state of the processing liquid between the nozzle and the substrate (hereinafter referred to as an abnormal film-thickness portion) may be generated. The formation of such an abnormal film-thickness portion on the valid area of the upper surface of the substrate adversely affects a subsequent process for the substrate.

With the above-mentioned configuration, invalid area information is acquired before the relative moving step. Further, a position at which the abnormal film-thickness portion is to be generated in the upper surface of the substrate can be predicted to some extent. Therefore, based on the acquired invalid area information and the position at which the abnormal film-thickness portion is predicted to be generated, the rotation position of the substrate in the substrate holder is adjusted. Thus, the abnormal film-thickness portion can be located in the invalid area of the upper surface of the substrate. As a result, a processing defect of the substrate caused by the process of applying the processing liquid is reduced.

(Item 8) The substrate processing method according to item 7, wherein a circuit pattern may be formed in the valid area of the upper surface of the substrate, the substrate processing method may further include detecting an area in which a circuit pattern is formed in the upper surface of the substrate and detecting an area excluding the area in which the circuit pattern is formed as the invalid area before the relative moving step, and the acquiring may include acquiring information of the invalid area detected in regard to the substrate as the invalid area information after the invalid area of the substrate is detected by the detecting and before the relative moving step in regard to the substrate.

In this case, before the processing liquid is applied to the substrate, the invalid area of the substrate is detected. Further, the rotation position of the substrate is adjusted based on the information of the detected actual invalid area. This enables adjustment of the rotation angle of the substrate with high reliability.

(Item 9) The substrate processing method according to item 7, may further include storing one or a plurality of invalid area information pieces that are predetermined in correspondence with one or a plurality of types of substrates in a storage, and the acquiring may include acquiring an invalid area information piece corresponding to a type of the substrate from among the one or plurality of types of invalid area information pieces stored in the storage in the storing before the relative moving step in regard to the substrate.

In this case, it is not necessary to provide the configuration for actually detecting the invalid area of the substrate. Therefore, it is possible to adjust the rotation position of the substrate while suppressing an increase in number of components.

(Item 10) The substrate processing method according to any one of items 7 to 9, wherein the acquiring may include further acquiring abnormal portion information representing an abnormal film-thickness portion that is predicted to be generated in a film of the processing liquid formed on the substrate in the relative moving step, before the relative moving step, and the adjusting may include adjusting a rotation position of the substrate held by the substrate holder such that the abnormal film-thickness portion is located in the invalid area based on the invalid area information and the abnormal portion information acquired in the acquiring before the relative moving step.

In this case, the abnormal film-thickness portion generated on the substrate after formation of a film of the processing liquid is located in the invalid area with high probability. Therefore, a processing defect of the substrate caused by the process of applying the processing liquid is more sufficiently reduced.

(Item 11) The substrate processing method according to any one of items 7 to 10, wherein the adjusting may include changing a rotation position of the substrate by rotating the substrate about an axis intersecting with the substrate with use of a substrate rotator, and receiving the substrate from the substrate rotator and transfer the substrate to the substrate holder.

In this case, the rotation position of the substrate held by the substrate holder can be adjusted with a simple configuration.

(Item 12) The substrate processing method according to any one of items 7 to 11, wherein the relative moving step may include, with a gap having a predetermined length formed between the upper surface of the substrate held by the substrate holder and the nozzle and with the gap filled with the processing liquid, relatively moving at least one of the substrate and the nozzle with respect to another one such that the processing liquid in the nozzle is drawn onto the upper surface of the substrate from the discharge port due to capillary action that occurs in the gap.

In this manner, it is possible to reduce an occurrence of a processing defect of the substrate caused by the coating process while improving the utilization efficiency of the processing liquid by supplying the coating liquid onto the substrate from the discharge port of the nozzle with utilization of capillary action.

With the substrate processing apparatus and the substrate processing method according to the above-mentioned embodiment, because the wasteful consumption of the processing liquid is suppressed, it is not necessary to generate a large amount of the processing liquid. Therefore, it is possible to contribute to a reduction in pollution of a global environment caused by the processing liquid.

While preferred embodiments of the present disclosure have been described above, it is to be understood that variations and modifications will be apparent to those skilled in the art without departing the scope and spirit of the present disclosure. The scope of the present disclosure, therefore, is to be determined solely by the following claims.

## Claims

1. A substrate processing apparatus that forms a film of a processing liquid on an upper surface of a substrate having an at least partially circular outer periphery,
the upper surface of the substrate including a valid area in which a circuit pattern is formed or to be formed and an invalid area excluding the valid area, and
the substrate processing apparatus comprising:
a substrate holder that holds the substrate;
a nozzle that has a slit-like discharge port extending in a first direction and discharges the processing liquid from the discharge port to the substrate held by the substrate holder;
a mover that performs a relative moving work for relative movement of at least one of the substrate holder and the nozzle with respect to another one in a second direction intersecting with the first direction such that the nozzle passes through a space above the substrate while discharging the processing liquid to the substrate;
an acquirer that acquires invalid area information representing the invalid area in the upper surface of the substrate before the relative moving work is performed; and
an adjuster that adjusts a rotation position of the substrate held by the substrate holder based on the invalid area information acquired by the acquirer before the relative moving work is performed.

2. The substrate processing apparatus according to claim 1, wherein
a circuit pattern is formed in the valid area of the upper surface of the substrate,
the substrate processing apparatus further includes
a detector that detects an area in which a circuit pattern is formed in the upper surface of the substrate and detects an area excluding the area in which the circuit pattern is formed as the invalid area before the relative moving work is performed, and
the acquirer acquires information of an invalid area detected in regard to the substrate as the invalid area information after the invalid area of the substrate is detected by the detector and before the relative moving work is performed in regard to the substrate.

3. The substrate processing apparatus according to claim 1, further comprising a storage that stores one or a plurality of types of invalid area information pieces that are predetermined in correspondence with one or a plurality of types of substrates, wherein
the acquirer acquires an invalid area information piece corresponding to a type of the substrate from among the one or plurality of types of invalid area information pieces stored in the storage before the relative moving work is performed in regard to the substrate.

4. The substrate processing apparatus according to any one of claims 1 to 3, wherein
the acquirer is configured to further acquire abnormal portion information representing an abnormal film-thickness portion that is predicted to be generated in a film of the processing liquid formed on the substrate by the relative moving work before the relative moving work is performed, and
the adjuster adjusts a rotation position of the substrate held by the substrate holder such that the abnormal film-thickness portion is located in the invalid area based on the invalid area information and the abnormal portion information acquired by the acquirer before the relative moving work is performed.

5. The substrate processing apparatus according to any one of claims 1 to 4, wherein
the adjuster includes
a substrate rotator configured to change a rotation position of the substrate by rotating the substrate about an axis intersecting with the substrate, and
a receiver-transferer that receives the substrate from the substrate rotator and transfer the substrate to the substrate holder.

6. The substrate processing apparatus according to any one of claims 1 to 5, wherein
the mover, during the relative moving work, with a gap having a predetermined length formed between the upper surface of the substrate held by the substrate holder and the nozzle and with the gap filled with the processing liquid, relatively moves at least one of the substrate and the nozzle with respect to another one such that the processing liquid in the nozzle is drawn onto the upper surface of the substrate from the discharge port due to capillary action that occurs in the gap.

7. A substrate processing method of forming a film of a processing liquid on an upper surface of a substrate having an at least partially circular outer periphery,
the upper surface of the substrate including a valid area in which a circuit pattern is formed or to be formed and an invalid area excluding the valid area, and
the substrate processing method including:
holding the substrate using a substrate holder;
a relative moving step of relatively moving at least one of the substrate holder and the nozzle with respect to another one in a second direction intersecting with a first direction such that a nozzle having a slit-like discharge port extending in the first direction passes through a space above the substrate while discharging the processing liquid from the discharge port to the substrate held by the substrate holder;
acquiring invalid area information representing the invalid area in the upper surface of the substrate before the relative moving step; and
adjusting a rotation position of the substrate held by the substrate holder based on the invalid area information acquired in the acquiring before the relative moving step.

8. The substrate processing method according to claim 7, wherein
a circuit pattern is formed in the valid area of the upper surface of the substrate,
the substrate processing method further includes
detecting an area in which a circuit pattern is formed in the upper surface of the substrate and detecting an area excluding the area in which the circuit pattern is formed as the invalid area before the relative moving step, and
the acquiring includes acquiring information of the invalid area detected in regard to the substrate as the invalid area information after the invalid area of the substrate is detected by the detecting and before the relative moving step in regard to the substrate.

9. The substrate processing method according to claim 7, further including:
storing one or a plurality of invalid area information pieces that are predetermined in correspondence with one or a plurality of types of substrates in a storage, and
the acquiring includes acquiring an invalid area information piece corresponding to a type of the substrate from among the one or plurality of types of invalid area information pieces stored in the storage in the storing before the relative moving step in regard to the substrate.

10. The substrate processing method according to any one of claims 7 to 9, wherein
the acquiring includes further acquiring abnormal portion information representing an abnormal film-thickness portion that is predicted to be generated in a film of the processing liquid formed on the substrate in the relative moving step, before the relative moving step, and
the adjusting includes adjusting a rotation position of the substrate held by the substrate holder such that the abnormal film-thickness portion is located in the invalid area based on the invalid area information and the abnormal portion information acquired in the acquiring before the relative moving step.

11. The substrate processing method according to any one of claims 7 to 10, wherein
the adjusting includes
changing a rotation position of the substrate by rotating the substrate about an axis intersecting with the substrate with use of a substrate rotator, and
receiving the substrate from the substrate rotator and transfer the substrate to the substrate holder.

12. The substrate processing method according to any one of claims 7 to 11, wherein
the relative moving step includes, with a gap having a predetermined length formed between the upper surface of the substrate held by the substrate holder and the nozzle and with the gap filled with the processing liquid, relatively moving at least one of the substrate and the nozzle with respect to another one such that the processing liquid in the nozzle is drawn onto the upper surface of the substrate from the discharge port due to capillary action that occurs in the gap.
